# EUROPEAN PATENT SPECIFICATION

(11) **EP 2 484 009 B1**
(45) Date of publication and mention of the grant of the patent: **12.11.2014**
(21) Application number: 10757787.6
(22) Date of filing: 29.09.2010
(51) Int. Cl.: H03J 1/00

(54) **REMOTE CONTROL DEVICE FOR BROADCAST RECEIVER**
FERNBEDIENUNG FÜR RUNDFUNKEMPFANGSVORRICHTUNG
COMMANDE À DISTANCE POUR DISPOSITIF DE RÉCEPTION DE DIFFUSION

(30) Priority: 01.10.2009 TR 200907470
(43) Date of publication of application: 08.08.2012
(73) Proprietor: Arçelik Anonim Sirketi, 34950 Istanbul (TR)
(72) Inventor: AYDIN, Bumin Kaan, 34950 Istanbul (TR); ESAME, Ibrahim Onur, 34950 Istanbul (TR)
(86) International application number: PCT/EP2010/064443
(87) International publication number: WO 2011/039246

(56) References cited:
- EP-A1- 1 578 016
- EP-A2- 0 352 446
- WO-A2-2007/066195

## Description

The present invention relates to a broadcast receiving device.

In broadcast receiving devices like television, satellite receiver, each program represents a channel memory field wherein the information like the name, frequency, symbol speed (for example TRT1, 11919 Hertz, 24444 symbol/second) belonging to a television or radio channel are recorded in the memory. The broadcast receiving devices comprise the sufficient number of channel memory fields, that is, programs in order to record the channels completely. The number of programs in broadcast receiving devices can go up to 10,000 programs varying between the range of 0-9,999 that are expressed by 4 digits.

The user desiring to watch a different channel than the current one, can switch between programs by means of the remote control buttons having numbers thereon. The broadcast receiving device not knowing beforehand how many digits the program number the user desires to switch result in prolonging the program switch time. For example, the user desiring to switch to program number 12, first presses button 1 and then button 2 of the remote control. However, a broadcast receiver, wherein the program numbers are expressed in 4 digits, receiving commands of 1 and 2, waits for a time period determined by the manufacturer (2 seconds on average) and then switches to the program number 12 taking into consideration the possibility that the user can switch to a 3 or 4 digit program like 12X or 12XY. The said awaiting time results in prolonging the program switching time and annoys the user.

In the state of the art European Patent Documents A No EP352446 and EP1578016, a broadcast receiver is explained wherein the program switching time is made shorter.

The aim of the present invention is the realization of a broadcast receiver wherein program switching time is shortened.

The broadcast receiver realized in order to attain the aim of the present invention, explicated in the first claim and the respective claims thereof, is controlled by a remote control comprising a numerical keypad which provides the numeric commands to be sent and at least one proximity sensor positioned such that it will make detection in the area covered by the numerical keypad. The proximity sensor provides a distance exceeded command to be sent when the distance of the user's finger to the keypad exceeds a certain value. The broadcast receiver comprises a memory having channel memory fields wherein the information related to the channels and furthermore wherein the received commands are recorded and a control card which provides the numeric commands sent by the remote control to be recorded in the memory. When the distance exceeded command is received, the control card, furthermore, provides switching to the program that represents the numeric commands recorded in the memory after the previous distance exceeded command. Thus, the switching of the program is provided when the user completes entering the desired program and removes his/her finger from the keypad.

In an embodiment of the present invention, the control card starts the waiting time determined by the manufacturer when a new numeric command is received. In this embodiment, if the distance exceeded command is received during the the waiting time, the control card provides switching to the program represented by the numeric commands recorded in the memory after the last program switch. If the distance exceeded command is not received within the waiting time, the control card provides switching to the program represented by the numeric commands recorded in the memory after the last program switch at the end of the waiting time. Thus, unchanging of the program is prevented in the situation when the user continues to hold the remote control after completing entering the program desired to be switched.

In another embodiment of the present invention, the proximity sensor functions according to the principle of capacitive detection.

A broadcast receiver realized in order to attain the aim of the present invention is illustrated in the attached figures, where:

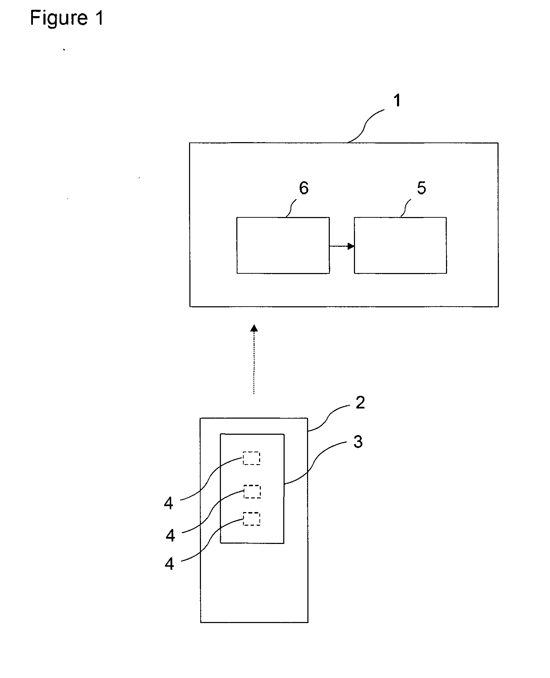

Figure 1 - is the schematic view of a broadcast receiver and a remote control.

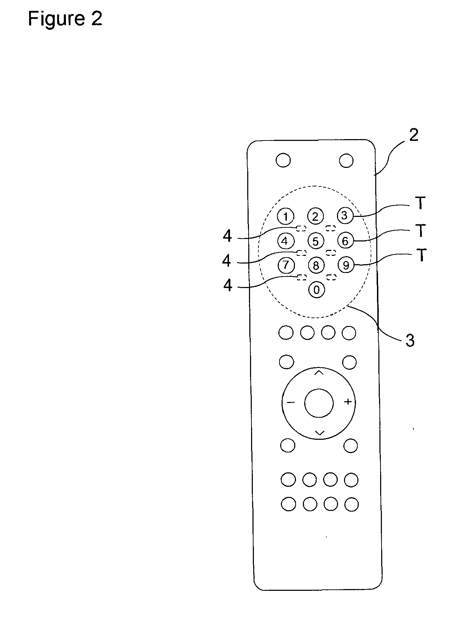

Figure 2 - is the front view of the remote control.

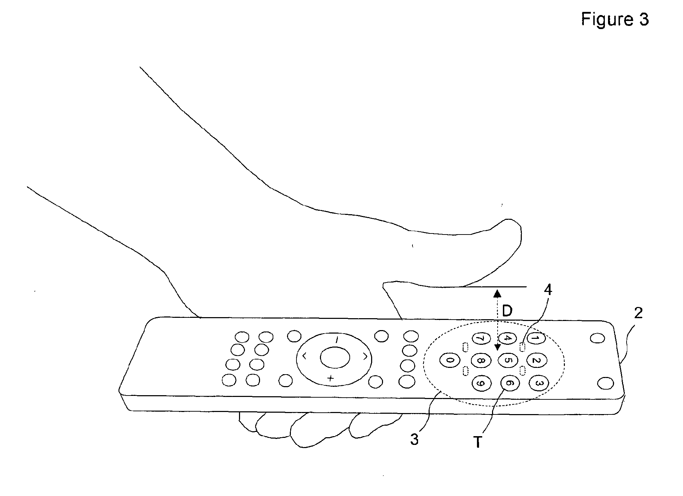

Figure 3 - is the view of the remote control held by the user.

The elements illustrated in the figures are numbered as follows:
1. Broadcast receiver
2. Remote control
3. Numerical keypad
4. Proximity sensor
5. Memory
6. Control card

A broadcast receiver (1) is controlled by a remote control (2) comprising
- a numerical keypad (3) having buttons (T) with numbers thereon and providing to send a numeric command corresponding to the numbers thereon and
- at least one proximity sensor (4), located under the numerical keypad (3) providing a distance exceeded command to be sent when the distance (D) of the user's finger to the keypad (3) exceeds a distance (D1) determined by the manufacturer.

The broadcast receiver (1) comprises
- a memory (5) having at least one channel memory field wherein the channel information is recorded and represented by a program and wherein the commands received from the remote control (2) are recorded and
   a control card (6) which provides to record the numeric commands received from the remote control (2) in the memory (5). The control card (6) provides switching to the program corresponding to the number represented by the numeric commands recorded in the memory (5) after the last program switch when a distance exceeded command generated by the proximity sensor (4) and delivered by the remote control (2) is received.

While the user enters the program number belonging to the channel desired to be watched by means of the numerical keypad (3), the received numeric commands are recorded in the memory (5) by means of the control card (6) on the side of the broadcast receiver (1). The program number that the user desires to switch to has one or more digits. Therefore, a single numeric command or a numeric command sequence is recorded in the memory (5). As the user enters the program number, his/her finger is almost on the numerical keypad (3). In the meantime, the proximity sensor (4) does not generate any commands. The control card (6) does not change the program since the distance exceeded command is not received. When the user completes entering the program number, his/her finger is removed from the numerical keypad (3). When the distance (D) of the user's finger to the numerical keypad (3) exceeds a distance (D1) determined by the manufacturer, the proximity sensor (4) provides a distance exceeded command to be sent by the remote control (2). When the distance exceeded command is received by the broadcast receiver (1), the control card (6) provides switching to the program corresponding to the number that is represented by the numeric commands recorded in the memory (5) after the last program switch. Thus, the program switch is achieved as soon as the user removes his/her finger from the numerical keypad (3), that is, as soon as the number of the program desired to be switched is entered.

In a model embodiment relating to program switching, the user watches the channel stored in program number 5 and desires to watch the channel stored in program number 12. The user first of all presses the button (T) with number 1 thereon in the numerical keypad (3). On the side of the broadcast receiver (1) the command of 1 is recorded in the memory (5) by means of the control card (6). The proximity sensor (4) does not generate any commands since the user has not yet removed his/her finger from the numerical keypad (3). The user then presses the button (T) with number 2 thereon in the numerical keypad (3). On the side of the broadcast receiver (1), the command of 2 is recorded in the memory (5) by means of the control card (6). When the user, after completing entering the program number, removes his/her finger from the numerical keypad (3) such as to exceed the distance (D1) determined by the manufacturer, the proximity sensor (4) provides a distance exceeded command to be sent. On the side of the broadcast receiver (1), when the distance exceeded command is received, the control card (6) provides switching to the program number 12 represented by numbers 1 and 2 recorded in the memory (5).

In an embodiment of the present invention, the control card (6) starts a the waiting time (for example 2 seconds) determined by the manufacturer as long as a numeric command is received. When the distance exceeded command is received within the waiting time or if the distance exceeded command is not received within the waiting time, then at the end of the waiting time, the control card (6) provides switching to the program corresponding to the number that is represented by the numeric commands recorded in the memory (5) after the last program switch.

In this embodiment of the present invention, while the user enters the program number belonging to the channel desired to be watched by means of the numerical keypad (3), the received numeric commands are recorded in the memory (5) by means of the control card (6) in the broadcast receiver (1). The control card (6) furthermore starts the waiting time determined by the manufacturer as numeric commands are received. After the user enters the last number belonging to the program number, and removes his/her finger from the numerical keypad (3) such as to exceed the distance (D1) determined by the manufacturer within the waiting time, the control card (6) provides switching to the program corresponding to the number represented by the numeric commands recorded in the memory (5) after the last program switch. After the user enters the last number belonging to the program number, within the waiting time, and does not remove his/her finger from the keypad (3) to exceed the distance (D1) determined by the manufacturer, the control card (6) provides switching to the program corresponding to the number represented by the numeric commands recorded in the memory (5) after the last program switch. Consequently, switching of the program is provided in the situation the user continues to hold the remote control (2) after completing to enter the program number.

In this embodiment of the present invention, in a model embodiment relating to program switching, the user watches the channel stored in program number 5 and desires to watch the channel stored in program number 12. The user first of all presses the button (T) with the number 1 thereon in the numerical keypad (3). On the side of broadcast receiver (1) the command of 1 is recorded in the memory (5) by means of the control card (6). The control card (6) furthermore starts the waiting time. The proximity sensor (4) does not generate any commands since the user has not yet removed his/her finger from the numerical keypad (3). When the user presses the button (T) having the number 2 thereon in the numerical keypad (3) within the waiting time, the command of 2 is recorded in the memory (5) by means of the control card (6) on the side of broadcast receiver (1). The control card (6) furthermore starts the waiting time again. When the user who completes to enter the program number removes his/her finger from the numerical keypad (3) such as to exceed the distance (D1) determined by the manufacturer, the proximity sensor (4) provides a distance exceeded command to be sent. on the side of broadcast receiver (1), when the distance exceeded command is received, the control card (6) provides switching to the program number 12 represented by the numbers 1 and 2 recorded in the memory (5). If the user who completes to enter the program number, does not remove his/her finger from the numerical keypad (3) such as to exceed the distance (D1) determined by the manufacturer during the the waiting time, the control card (6) provides switching to the program represented by numbers 1 and 2 and recorded in the memory (5) at the end of the waiting time.

In another embodiment of the present invention, the proximity sensor (4) is a capacitive proximity sensor.

It is to be understood that the present invention is not limited to the embodiments disclosed above and a person skilled in the art can easily introduce different embodiments. These should be considered within the scope of the protection postulated by the claims of the present invention.

## Claims

1. A broadcast receiver (1) controlled by a remote control (2) comprising
- a numerical keypad (3) having buttons (T) with numbers thereon and providing to send a numeric command corresponding to the numbers thereon and comprising
- a memory (5) having at least one channel memory field wherein the channel information is recorded and represented by a program and wherein the commands received from the remote control (2) are recorded and
- a control card (6) which provides to record the numeric commands received from the remote control (2) in the memory (5)
**characterized by**
- at least one proximity sensor (4), disposed under the numerical keypad (3) providing to send a distance exceeded command when the distance (D) of the user's finger to the keypad (3) exceeds a distance (D1) determined by the manufacturer and
- the control card (6) which provides switching to the program corresponding to the number represented by the numeric commands recorded in the memory (5) after the last program switch when a distance exceeded command generated by the proximity sensor (4) and delivered by the remote control (2) is received.

2. A broadcast receiver (1) as in Claim 1, **characterized by** the control card (6) that starts the waiting time determined by the manufacturer when a numeric command is received, and at the end of the waiting time provides switching to the program corresponding to the number represented by the numeric commands recorded in the memory (5) after the last program switch when the distance exceeded command is received within the waiting time or if the distance exceeded command is not received within the waiting time.

3. A broadcast receiver (1) as in Claim 1, which is controlled by the remote control (2) comprising a capacitive proximity sensor (4).

## Patentansprüche

1. Rundfunkempfänger (1), der durch eine Fernbedienung (2) gesteuert wird, umfassend
o einen Ziffernblock (3) mit Tasten (T) mit Ziffern darauf, der es ermöglicht, einen numerischen Befehl zu senden, der den Ziffern darauf entspricht, und umfassend
o einen Speicher (5) mit wenigstens einem Kanalspeicherfeld, in dem die Kanalinformationen aufgezeichnet sind und durch ein Programm dargestellt werden, und in dem die von der Fernbedienung (2) empfangenen Befehle aufgezeichnet werden, und
o eine Steuerkarte (6), dies es ermöglicht, die von der Fernbedienung (2) empfangenen numerischen Befehle im Speicher (5) zu speichern,
**gekennzeichnet durch**
o wenigstens einen Näherungssensor (4), der unter dem Ziffernblock (3) angeordnet ist und es ermöglicht, einen Abstandsüberschreitungsbefehl zu senden, wenn der Abstand (D) des Fingers des Benutzers zum Ziffernblock (3) einen vom Hersteller festgelegten Abstand (D1) überschreitet, und
o die Steuerkarte (6), die es ermöglicht, das Programm entsprechend der Zahl umzuschalten, die von den im Speicher (5) aufgezeichneten numerischen Befehlen dargestellt wird, wenn ein Abstandsüberschreitungsbefehl, der vom Näherungssensor (4) erzeugt und von der Fernbedienung (2) bereitgestellt wird, empfangen wird.

2. Rundfunkempfänger (1) nach Anspruch 1, **dadurch gekennzeichnet, dass** die Steuerkarte (6) die vom Hersteller festgelegte Wartezeit startet, wenn ein numerischer Befehl empfangen wird, und am Ende der Wartezeit ermöglicht, zu dem Programm umzuschalten, das der Zahl entspricht, die von den nach dem letzten Programmwechsel im Speicher (5) aufgezeichneten numerischen Befehlen dargestellt wird, wenn der Abstandsüberschreitungsbefehl innerhalb der Wartezeit empfangen wird oder wenn der Abstandsüberschreitungsbefehl nicht innerhalb der Wartezeit empfangen wird.

3. Rundfunkempfänger (1) nach Anspruch 1, der durch eine Fernbedienung (2) gesteuert wird, die einen kapazitiven Näherungssensor (4) umfasst.

## Revendications

1. Un récepteur de radiodiffusion (1) commandé par une télécommande (2) comprenant
o un clavier numérique (3) qui présente des touches (T) avec des nombres sur celles-ci et qui assure qu'une commande numérique correspondant à des nombres sur celle-ci est envoyée et comprenant
o une mémoire (5) présentant au moins un champ de mémoire de chaîne où les informations de chaîne sont enregistrées et représentées par un programme et où les commandes reçues de la télécommande (2) sont enregistrées et
o une carte de commande (6) qui permet l'enregistrement des commandes numériques reçues de la télécommande (2) dans la mémoire (5)
**caractérisé par**
o au moins un capteur de proximité (4) qui est disposé au-dessous du clavier numérique (3), assurant qu'une commande de dépassement de distance est envoyée lorsque la distance (D) entre le doigt de l'utilisateur et le clavier (3) dépasse une distance (D1) déterminée par le fabricant et
o la carte de commande (6) qui permet de changer au programme correspondant au nombre représenté par les commandes numériques enregistrées dans la mémoire (5) après le dernier changement de programme lorsqu'une commande de dépassement de distance générée par le capteur de proximité (4) et envoyée par la télécommande (2) est reçue.

2. Un récepteur de radiodiffusion (1) selon la Revendication 1, **caractérisé par** la carte de commande (6) qui commence le temps d'attente déterminé par le fabricant lorsqu'une commande numérique est reçue, et à la fin du temps d'attente qui permet de changer au programme correspondant au nombre représenté par les commandes numériques enregistrées dans la mémoire (5) après le dernier changement de programme lorsque la commande de dépassement de distance est reçue dans le temps d'attente ou si la commande de dépassement de distance n'est pas reçue dans le temps d'attente.

3. Un récepteur de radiodiffusion (1) selon la Revendication 1, qui est commandé par la télécommande (2) comprenant un capteur de proximité capacitif (4).
